# EUROPÄISCHE PATENTSCHRIFT

(11) **EP 1 565 943 B1**
(45) Veröffentlichungstag und Bekanntmachung des Hinweises auf die Patenterteilung: **29.03.2017**
(21) Anmeldenummer: 03767457.9
(22) Anmeldetag: 26.11.2003
(51) Int. Cl.: H01L 29/06, H01L 29/78, H01L 29/08

(54) **TRANSISTOR MIT FÜLLBEREICHEN IM SOURCE- UND/ODER DRAINGEBIET**
TRANSISTOR COMPRISING FILL AREAS IN THE SOURCE AND/OR DRAIN REGION
TRANSISTOR COMPORTANT DES ZONES DE REMPLISSAGE DANS LA ZONE SOURCE ET/OU LA ZONE DRAIN

(30) Priorität: 27.11.2002 DE 10255359
(43) Veröffentlichungstag der Anmeldung: 24.08.2005
(73) Patentinhaber: Infineon Technologies AG, 85579 Neubiberg (DE)
(72) Erfinder: ESMARK, Kai, 82069 Neuried (DE); RIESS, Philipp, 80469 Muenchen (US); SCHAFBAUER, Thomas, F-75013 Paris (FR); STREIBL, Martin, 85238 Petershausen (DE); WENDEL, Martin, 85662 Hohenbrunn (DE)
(74) Vertreter: Patentanwälte Lambsdorff & Lange
(86) Internationale Anmeldenummer: PCT/DE2003/003914
(87) Internationale Veröffentlichungsnummer: WO 2004/049450

(56) Entgegenhaltungen:
- EP-A- 1 073 123
- DE-C1- 10 054 184
- JP-A- H11 340 460
- JP-A- 2001 085 512
- US-A- 4 845 536
- US-A- 5 721 439
- US-A- 6 096 609
- US-A1- 2001 005 022
- US-A1- 2002 096 697
- PATENT ABSTRACTS OF JAPAN vol. 2000, no. 13, 5. Februar 2001 (2001-02-05) & JP 2000 286417 A (TOSHIBA CORP), 13. Oktober 2000 (2000-10-13)
- FUJIHIRA T: "THEORY OF SEMICONDUCTOR SUPERJUNCTION DEVICES" JAPANESE JOURNAL OF APPLIED PHYSICS, PUBLICATION OFFICE JAPANESE JOURNAL OF APPLIED PHYSICS. TOKYO, JP, Bd. 36, Nr. 10, Oktober 1997 (1997-10), Seiten 6254-6262, XP000918328 ISSN: 0021-4922

## Beschreibung

Die Erfindung betrifft einen Transistor nach dem Oberbegriff des Anspruchs 1, welcher Füllbereiche aufweist, die im Source- und/oder Draingebiet des Transistors angeordnet sind.

In modernen Technologien zur Herstellung von HalbleiterBauelementen und integrierten Schaltkreisen treten in zunehmenden Masse Skaleneffekte auf. Technologieparameter wie beispielsweise Schichtwiderstände zeigen dabei unerwünschte Abhängigkeiten von den Strukturgrößen der jeweils verwendeten Technologie. Ein Beispiel hierfür sind Metallflächen, bei denen beim Erreichen bestimmter Flächengrößen Probleme beim chemisch-mechanischen Polieren (CMP) auftreten. Zur Lösung dieses Problems werden in neueren Technologien in einigen Maskenebenen regelmäßige Füllstrukturen eingebracht, welche die Dichte einer bspw. Metallebene oder Poly-Siliziumebene über dem Wafer homogenisieren sollen.

Wie in Bauelement-Simulationen und Experimenten beobachtet wurde, hängt die Einsatzspannung eines Transistors (Spannung, bei der der Transistor beginnt Strom zu leiten) von der Größe seines Diffusionsgebietes ab. Daraus resultiert eine erhebliche Streuung der Einsatzspannung sowie auch anderer Kenngrößen eines Transistors auf dem Chip, abhängig von der Größe, der Geometrie und der Umgebung der auf einem Chip ausgebildeten Transistoren. Dies bedingt erhebliche Probleme bei der Schaltungssimulation oder dem aufeinander Abstimmen von Schaltungen (Matching). Dies trifft im Besonderen auf Treibertransistoren zu, die aufgrund ihrer hohen Ausgangsleistung eine große Transistorweite benötigen. Noch weiter verstärkt wird der Effekt bei Transistoren, die unmittelbar mit Eingangs-/oder Ausgangsanschlüssen der integrierten Schaltung verbunden sind und so bei elektrostatischen Entladungen besonders gefährdet sind (ESD-Transistoren). Diese ESD-Transistoren benötigen als Schutzmaßnahme eine Mindestgröße der Diffusionsgebiete, woraus eine relativ große Weite als auch Höhe der Diffusionsgebiete resultiert und diese ESD-Transistoren daher besonders stark von der Kennlinienverschiebung betroffen sind.

Aus der deutschen Patentschrift DE 100 54 184 C1 ist ein ESD-Transistor bekannt, bei dem zur Verbesserung seiner ESD-Festigkeit und seiner gleichzeitig unbeeinträchtigten Treiberfähigkeit, streifenförmige Isolationsbereiche in den Diffusionsgebieten des Transistors eingebettet sind. Die streifenförmigen Bereiche weisen dabei eine vertikale Ausdehnung auf, die kleiner als die vertikale Ausdehnung des Source- und/oder Draingebietes des Transistors ist. Diese streifenförmigen Isolationsbereiche sind parallel zueinander und separiert voneinander angeordnet und senkrecht zum Gate-Bereich ausgebildet. Dadurch werden Stromeinschnürungen im Bereich des Diffusionsgebietes vermieden und durch die Verminderung der zur Stromleitung zur Verfügung stehenden effektiven Fläche der erwünschte Effekt einer Erhöhung des Diffusionswiderstands erreicht. Es kann vorgesehen sein, die streifenförmige Struktur auch in eine auf den Diffusionsgebieten ausgebildete Salizid-Schicht zu übertragen. Zur Beibehaltung der Treiberfähigkeit des Transistors enden die streifenförmigen Isolationsbereiche in einem bestimmten Abstand vor dem Kanalgebiet des Transistors. Ein Nachteil dieser Struktur besteht darin, dass lediglich die ESD-Festigkeit verbessert werden kann. Die gezielte Vermeidung von Kennlinienverschiebungen der Transistoren, insbesondere der Verschiebung der Einsatzspannung, bedingt durch die eingangs erläuterten Effekte, ist dadurch nicht möglich.

Des Weiteren ist aus der US 5,721,439 ein Transistor bekannt, bei dem zur Verbesserung der ESD-Festigkeit streifenförmige Bereiche parallel zum Gate-Bereich des Transistors ausgebildet sind. Die streifenförmigen Bereiche sind in ihrer Längsrichtung zueinander versetzt. Die streifenförmigen Bereiche weisen einen Oxid-Bereich und einen darauf ausgebildeten Poly-Slilizium-Bereich auf und sind lediglich auf der Substratoberfläche ausgebildet. Die Diffusionsgebiete der Transistoren erstrecken sich innerhalb des Substrats zwischen den Bereichen der streifenförmigen Bereiche. In den Diffusionsgebieten sind keine weiteren Bereiche, bspw. als Isolationsbereiche, ausgebildet. Eine Kennlinienverschiebung der Transistoren aufgrund der eingangs geschilderten Effekte kann daher nicht verhindert werden.

Weiterhin ist ein Transistor aus der US 6,153,909 bekannt, bei dem zur Vermeidung von Hot-Carrier-Effekten Isolationsbereiche innerhalb der Diffusionsgebiete des Transistors angeordnet sind. Die Isolationsbereiche sind kastenförmig lediglich in das Diffusionsgebiet eingebettet und weisen vertikal kleinere Ausmasse auf, als die Diffusionsgebiete. Um eine Verminderung des Hot-Carrier-Effektes zu erreichen, ist es notwendig die Isolationsbereiche mindestens teilweise unterhalb von Spacerbereichen bzw. unterhalb des Gate-Bereichs auszubilden. Eine gezielte Vermeidung der Kennlinienverschiebung ist auch bei dieser bekannten Transistorausbildung nicht gegeben.

Daher ist es Aufgabe der Erfindung, einen Transistor zu schaffen, bei dem eine Kennlinienverschiebung, insbesondere aufgrund der Geometrie und der Größe des Transistors, reduziert werden kann.

Diese Aufgabe wird durch einen Transistor, welcher die Merkmale nach Patentanspruch 1 aufweist, gelöst.

Ein erfindungsgemäßer Transistor weist ein Sourcegebiet und ein Draingebiet auf. Beide Gebiete sind in einem Substrat ausgebildet. Des Weiteren weist der Transistor eine Mehrzahl von Füllbereichen auf, wobei jeder Füllbereich zumindest teilweise im Substrat angeordnet ist, und sich die Füllbereiche und das Source- und/oder Draingebiet ineinander erstrecken. Ein wesentlicher Gedanke der Erfindung ist es, dass die Füllbereiche vertikale Ausmaße aufweisen, die mindestens gleich groß den vertikalen Ausmaßen des Source- und/oder Draingebietes sind. Dadurch kann ein Transistor realisiert werden, bei dem eine Verschiebung von Kenngrößen und speziell eine Kennlinienverschiebung, insbesondere eine Verschiebung seiner Einsatzspannung, unabhängig von seiner Größe, seiner Geometrie oder seiner Umgebung, in der er beispielsweise in einem integrierten Schaltkreis ausgebildet ist, reduziert oder verhindert werden kann. Allgemein kann dadurch jeder beliebige Transistor, der auf einem integrierten Schaltkreis realisiert ist, entsprechend dem erfindungsgemäßen Transistor ausgebildet sein. Eine Streuung der Transistor-Kenngrößen, insbesondere der Einsatzspannung, kann dadurch wirksam begrenzt werden, so dass die Simulation von Schaltungen oder das Abstimmen von Schaltungen aufeinander wesentlich genauer, einfacher und in einer optimierten Weise erfolgen kann.

In einem besonders bevorzugten Ausführungsbeispiel sind die Füllbereiche derart angeordnet, dass das Source- und/oder Draingebiet in vertikaler Richtung vollständig von den Füllbereichen durchdrungen sind. Indem die Füllbereiche das Source- und/oder Draingebiet in vertikaler Richtung durchdringen, kann in besonders effektiver und effizienter Weise eine Kenngrößenverschiebung des Transistors verhindert werden.

Nicht Bestandteil der Erfindung ist es, die Füllbereiche einstückig und im Wesentlichen homogen auszubilden. Auch nicht Bestandteil der Erfindung ist, dass die Füllbereiche und das Source- und/oder Draingebiet an der dem Substrat abgewandten Oberfläche eine im Wesentlichen planare Fläche bilden. Es kann vorgesehen sein, dass ausgehend von dieser planaren Oberfläche die Füllbereiche eine Tiefe aufweisen, die größer ist als die Tiefe des Source- und/oder Draingebietes. Vom Substrat aus betrachtet, weisen dadurch die Füllbereiche zum Substrat einen kleineren Abstand auf, als ihn das Source- und/oder Draingebiet zum Substrat aufweist.

Erfindungsgemäß sind die Füllbereiche jeweils zumindest aus zwei Teilstücken aufgebaut welche in vertikaler Richtung übereinander angeordnet sind. Es kann dabei vorgesehen sein, dass ein jeweils erstes Teilstück eines Füllbereichs einstückig und im Wesentlichen homogen ausgebildet ist. Es bildet mit dem Source- und/oder Draingebiet an der dem Substrat abgewandten Oberfläche eine im Wesentlichen planare Fläche. Ebenso kann vorgesehen sein, dass dieses erste Teilstück eines jeden Füllbereichs mit einem Abstand zum Substrat ausgebildet ist, der kleiner ist als der Abstand den das Source- und/oder Draingebiet zum Substrat aufweist. Ebenso kann jedoch auch vorgesehen sein, dass dieser Abstand dieses ersten Teilstückes eines Füllbereichs zum Substrat hin größer ist, als der Abstand des Source- und/oder Draingebietes zum Substrat. Das erste Teilstück eines Füllbereichs eines aus zumindest zwei Teilstücken zusammengesetzten Füllbereichs kann dadurch in vielfältiger Weise realisiert sein. Das erste Teilstück kann daher als oberes oder unteres Endstück eines zusammengesetzten Füllbereichs, als auch zwischen einem zweiten und einem dritten Teilstück eines zusammengesetzten Füllbereichs ausgebildet sein. Das erste Teilstück für sich betrachtet kann somit vertikale Ausmaße aufweisen, die kleiner, gleich groß oder größer den vertikalen Ausmaßen des Source- und/oder Draingebietes sind.

Es ist vorgesehen, dass zumindest ein zweites Teilstück eines jeweiligen Füllbereichs deckungsgleich zu dem ersten Teilstück und in vertikaler Richtung betrachtet, auf oder unterhalb diesem ersten Teilstück angeordnet ist. Abhängig von der verwendeten Technologie zur Herstellung der Bauelemente in einem integrierten Schaltkreis kann dadurch eine zusätzliche Verbesserung im Hinblick auf eine mögliche Verschiebung der Kennlinien des Transistors erreicht werden. In besonders vorteilhafter Weise sind die Füllbereiche im Vergleich zu dem Source- und/oder Draingebiet zumindest in Teilbereichen elektrisch isolierend. Es kann dabei vorgesehen sein, dass der gesamte Füllbereich schwach elektrisch leitend ist. Es kann aber auch vorgesehen sein, dass der aus mehreren Teilstücken zusammengesetzte Füllbereich zumindest ein erstes Teilstück aufweist, welches schwach elektrisch leitend ist und zumindest ein zweites Teilstück aufweist, welches elektrisch isolierend ist.

Besonders vorteilhaft ist es, wenn die Teilstücke eines Füllbereiches als Oxid-Bereich, insbesondere als Siliziumdioxid-Bereich, und/oder als Nitrid-Bereich ausgebildet sind.

In vorteilhafter Weise sind Teilstücke der Füllbereiche als Wannenbereiche ausgebildet, welche relativ hochohmig sind. Das Source- und/oder Draingebiet ist dabei in dem Wannenbereich eingebettet, wobei der Wannenbereich in dem Substrat ausgebildet ist und die Füllbereiche Teilbereiche des Wannenbereichs sind. Die schwach elektrisch leitenden Teilstücke eines Füllbereichs sind aus Poly-Silizium ausgebildet. Nicht Bestandteil der Erfindung ist dass die Füllbereiche vollständig aus Wannenbereichen gebildet sind. Des Weiteren kann vorgesehen sein, dass jeder Füllbereich ein drittes Teilstück aufweist, welches aus Poly-Silizium ist und unmittelbar auf dem ersten Teilstück oder dem zweiten Teilstück angeordnet ist. Auch hier kann jedes einzelne Teilstück eines Füllbereichs vertikale Ausmaße aufweisen, die kleiner sind als die vertikalen Ausmaße des Source- und/oder Draingebietes. Die Füllbereiche können somit in vielfältiger Weise aus mehreren Teilstücken sowie als vollständig schwach elektrisch leitend oder in Teilbereichen vollständig elektrisch isolierend und in Teilbereichen schwach elektrisch leitend ausgebildet sein.

In einem vorteilhaften Ausführungsbeispiel sind die Füllbereiche als im Wesentlichen parallel zueinander angeordnete Streifen ausgebildet, die insbesondere in derjenigen Ebene, in der sich der Gate-Bereich des Transistors erstreckt, senkrecht zu diesem Gate-Bereich angeordnet sind. Es kann aber auch vorgesehen sein, dass die Füllbereiche als Vollzylinder oder als Hohlzylinder oder als eckige Säulen ausgebildet sind. Die geometrische Gestaltung der Füllbereiche ist durch die genannten konkreten Ausführungsbeispiele nicht beschränkt, sondern kann in vielfältiger Weise geometrisch gestaltet sein. Wesentlich ist jedoch, dass die Gestaltung der Füllbereiche sowie ihrer Anordnung derart ausgebildet ist, dass eine Verschiebung von Kenngrößen bzw. Kennlinien, insbesondere der Einsatzspannung, des Transistors verhindert wird. In vorteilhafter Weise kann auch vorgesehen sein, dass auf dem Source- und/oder Draingebiet und/oder auf den Füllbereichen eine Salizid-Schicht ausgebildet ist. Es kann vorgesehen sein, dass die Struktur der Füllbereiche auch in dieser Salizid-Schicht ausgebildet ist.

Weitere vorteilhafte Ausgestaltungen der Erfindung sind in den Unteransprüchen und in der nachfolgenden Beschreibung von Ausführungsbeispielen gegeben.

Nachfolgend werden einige Ausführungsbeispiele der Erfindung anhand schematischer Zeichnungen näher erläutert. Es zeigen:
- Fig. 1: eine Draufsicht auf einen Transistor;

- Fig. 2: eine Schnittdarstellung des Transistors in abgewandelter Form;
- Fig. 3: eine Schnittdarstellung eines ersten Ausführungsbeispiels eines erfindungsgemäßen Transistors;
- Fig. 4: eine Schnittdarstellung eines zweiten Ausführungsbeispiels eines erfindungsgemäßen Transistors;
- Fig. 5: eine Draufsicht auf ein dritten Ausführungsbeispiel eines erfindungsgemäßen Transistors;
- Fig. 6: eine weitere Draufsicht eines vierten Ausführungsbeispiels eines erfindungsgemäßen Transistors; und
- Fig. 7: eine Schnittdarstellung eines fünften Ausführungsbeispiels eines erfindungsgemäßen Transistors.

In den Figuren werden gleiche oder funktionsgleiche Elemente mit gleichen Bezugszeichen versehen.

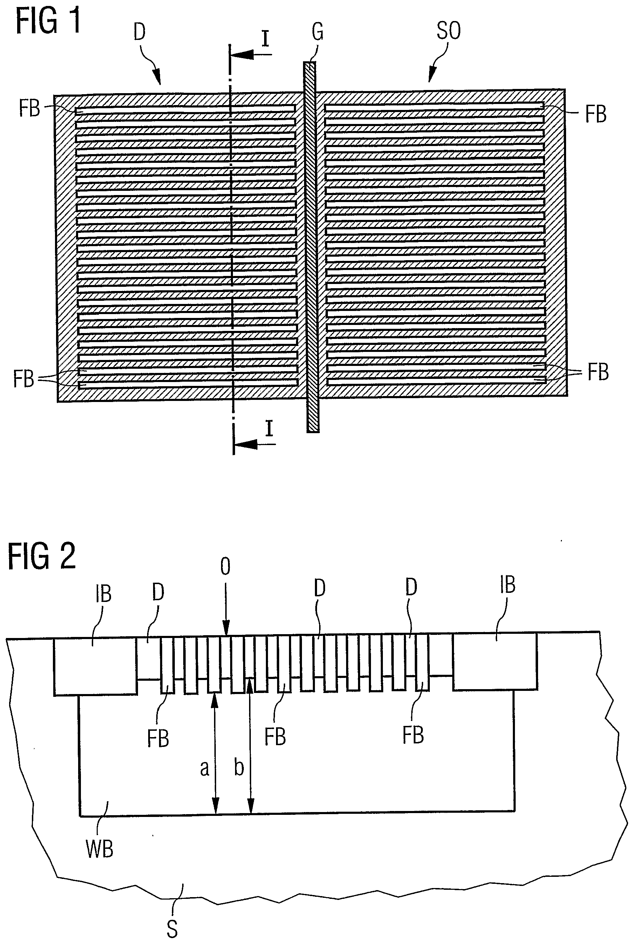

In Fig. 1 ist eine Draufsicht auf einen Transistor gezeigt. Der Transistor weist ein Draingebiet D und ein Sourcegebiet SO auf. Ein länglich ausgebildeter Gate-Bereich G erstreckt sich zwischen den beiden Diffusionsgebieten D und SO. In dem Draingebiet D sind streifenförmige Füllbereiche FB ausgebildet, die parallel und im Wesentlichen äquidistant zueinander angeordnet sind und sich in der Ebene, in der sich der Gate-Bereich G erstreckt, senkrecht zu diesem Gate-Bereich G angeordnet sind. In analoger Weise sind diese Füllbereiche FB in dem Sourcegebiet SO angeordnet. Die Füllbereiche FB sind derart angeordnet, dass sie das jeweilige Diffusionsgebiet, in dem sie ausgebildet sind, nahezu vollständig durchziehen und vom Gate-Bereich G beabstandet ausgebildet sind.

Eine Schnittdarstellung des Transistors ist in Fig. 2 gezeigt. Fig. 2 zeigt einen Schnitt entlang der Linie II (Fig. 1), wobei die Schnittdarstellung in einigen Punkten von der Draufsicht gemäß Fig. 1 abweicht. So weist die Schnittdarstellung gemäß Fig. 2 Isolationsbereiche IB auf, mit denen eine Isolation des Drain- und/oder Sourcegebietes D und SO von benachbarten Diffusionsgebieten angrenzender Transistoren ermöglicht wird, die in Fig. 1 nicht dargestellt sind. Darüber hinaus ist in Fig. 2 die Anzahl der Füllbereiche FB geringer als die Anzahl der Füllbereiche FB gemäß Fig. 1. In der Schnittdarstellung des Transistors in Fig. 2, ist das Draingebiet D in einem Wannenbereich WB ausgebildet. Der Wannenbereich WB ist in einem Substrat S ausgebildet. Die streifenförmigen Füllbereiche FB sind in horizontaler Richtung äquidistant zueinander angeordnet. Bei diesem Transistor sind diese Füllbereiche FB einstückig ausgebildet und als Streifen aus Siliziumdioxid erzeugt. Die Füllbereiche FB bilden auf der dem Substrat S abgewandten Seite mit dem Drain-Diffusionsgebiet D eine im Wesentlichen planare Oberfläche O. Ausgehend von dieser planaren Oberfläche O erstrecken sich die Füllbereiche FB bis in eine Tiefe, die größer ist als die Tiefe, in die sich das Drain-Diffusionsgebiet D ausgehend von dieser planaren Oberfläche O erstreckt. Die Füllbereiche FB durchdringen somit das Draingebiet D vollständig und weisen vertikale Ausmaße auf, die größer sind als die vertikalen Ausmaße des Draingebietes D. Der Abstand a der Füllbereiche FB von der Substratoberfläche, welche hier durch den Übergang zwischen dem Wannenbereich WB (Wannenboden) und dem Substrat S gegeben ist, ist kleiner als der Abstand b, den der untere Bereich des Draingebietes D von dieser Substratoberfläche aufweist. Es kann jedoch auch vorgesehen sein, dass die einstückigen Füllbereiche FB derart angeordnet sind, dass sie zur Substratoberfläche bzw. zum Boden des Wannenbereichs WB einen größeren Abstand aufweisen, als die unteren Bereiche des Drain-Diffusionsgebietes D. Es kann auch vorgesehen sein, dass die Füllbereiche FB das Draingebiet D vollständig durchsetzen und die Füllbereiche FB und das Draingebiet D den gleichen Abstand zum Bodenbereich des Wannenbereichs WB aufweisen. Ebenso kann vorgesehen sein, dass sich die Füllbereich FB über die Oberfläche O hinaus erstrecken.

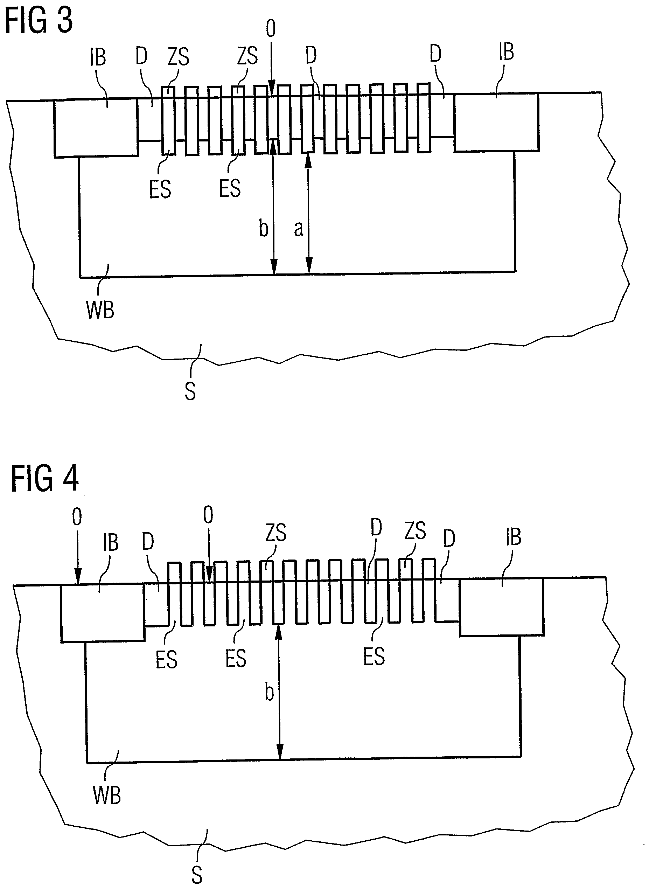

Ein erstes Ausführungsbeispiel des erfindungsgemäßen Transistors ist in der Schnittdarstellung gemäß Fig. 3 gezeigt. In diesem Ausführungsbeispiel sind die Füllbereiche FB aus zwei Teilstücken aufgebaut. Die ersten Teilstücke ES jedes Füllbereichs sind entsprechend den Füllbereichen FB gemäß Fig. 2 ausgebildet. Zusätzlich weist jeder Füllbereich FB in Fig. 3 ein zweites Teilstück ZS auf, welches in vertikaler Richtung auf dem ersten Teilstück ES angeordnet ist. Das zweite Teilstück ZS jedes Füllbereichs FB, welcher sich aus dem ersten Teilstück ES und dem zweiten Teilstück ZS zusammensetzt, ist aus Poly-Silizium gebildet. In diesem Ausführungsbeispiel weist jeder Füllbereich FB somit einen elektrisch isolierenden Bereich, welcher durch das erste Teilstück ES gebildet ist, und einen schwach elektrisch leitenden Bereich, welcher durch das zweite Teilstück ZS gebildet ist, auf. Auch in diesem Ausführungsbeispiel kann die Anordnung der Füllbereiche FB in vielfältiger Weise realisiert sein. Es kann auch hier vorgesehen sein, dass die Abstände des Draingebietes D von der Substratoberfläche bzw. vom Bodenbereich des Wannenbereichs WB gleich oder kleiner dem Abstand der ersten Teilstücke ES der Füllbereiche FB sind. Die zweiten Teilstücke ZS sind deckungsgleich zu den ersten Teilstücken ES ausgebildet. Ein zweites Ausführungsbeispiel des erfindungsgemäßen Transistors ist in Fig. 4 dargestellt. In diesem Ausführungsbeispiel sind die Füllbereiche FB ebenfalls aus zwei Teilstücken aufgebaut. Die ersten Teilstücke ES sind, wie in der Schnittdarstellung in Fig. 4 zu erkennen ist, durch Teilbereiche des Wannenbereichs WB gebildet. Diese ersten Teilstücke ES sind somit homogene Bereiche des Wannenbereichs WB, die sich bis zur Oberfläche O hin erstrecken. Auch in diesem Ausführungsbeispiel sind die Füllbereiche FB als Streifen realisiert. Anzumerken ist bei diesem Ausführungsbeispiel, dass das Draingebiet D in den Wannenbereich WB eingebettet ist, und aufgrund des Durchdringens der ersten Teilstücke ES der Füllbereiche FB, eine streifenförmige bzw. lamellenförmige Struktur aufweist, wobei die parallelen Streifen des Draingebiets D an den Enden jeweils miteinander verbunden sind. Zusätzlich zu den ersten Teilstücken ES weisen die Füllbereiche FB auch in diesem Ausführungsbeispiel zweite Teilstücke ZS auf, die auf den ersten Teilstücken ES angeordnet sind und aus PolySilizium gebildet sind. Da die Füllbereiche FB, insbesondere die ersten Teilstücke ES, in diesem Ausführungsbeispiel durch Teilbereiche des Wannenbereichs WB gebildet werden, in dem das Draingebiet D vollständig eingebettet ist, erstrecken sich in diesem Ausführungsbeispiel die Füllbereiche FB logischerweise mit einer größeren Tiefe als das Draingebiet D. Ein Abstand a ist daher in diesem Ausführungsbeispiel nicht gegeben. In diesem Ausführungsbeispiel werden die streifenförmigen Bereiche des Draingebietes D durch Implantation in den Wannenbereich WB erzeugt. Auch das dritte Ausführungsbeispiel gemäß Fig. 4 kann in vielfältiger Weise abgeändert werden.

Durch die in den Ausführungsbeispielen gemäß Fig. 3 und Fig. 4 gezeigten zusätzlichen zweiten Teilstücke ZS aus Poly-Silizium, kann ein weiterer positiver Einfluss im Hinblick auf die Verschiebung der Einsatzspannung des Transistors erreicht werden, indem die relativ großen Diffusionsgebiete des Transistors quasi unterbrochen werden. Durch diese Poly-Silizium-Teilstücke ZS werden die Gitterspannungen in den Diffusionsgebieten des Transistors verringert. Dadurch kann in bestimmten Fertigungstechnologien eine noch effektivere Vermeidung von Kennlinienverschiebungen erzielt werden. Darüber hinaus kann aufgrund dieser Poly-Silizium-Teilstücke eine höhere lithographische Präzision erzielt werden, da quasi zusätzliche Poly-Silizium-Bereiche vorhanden sind und eine möglichst hohe und gleichmäßig auf dem Chip verteilte PolySilizium-Dichte eine gute Lithographie gewährleisten kann.

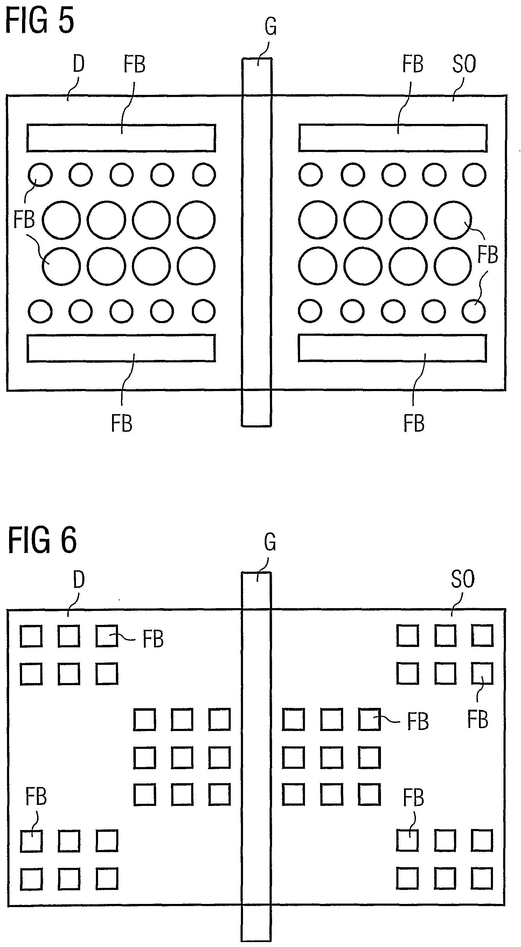

In Fig. 5 ist ein weiteres Ausführungsbeispiel eines erfindungsgemäßen Transistors dargestellt. In dieser Draufsicht sind sowohl in dem Draingebiet D als auch in dem Source-Diffusionsgebiet SO eine Mehrzahl an Füllbereichen FB dargestellt, wobei sich die Füllbereiche FB aus streifenförmigen Füllbereichen FB und vollzylinderförmigen Füllbereichen FB zusammensetzen. Einige der vollzylinderförmigen Füllbereiche FB weisen einen ersten Durchmesser auf, welcher kleiner ist als ein Durchmesser von zweiten vollzylinderförmigen Füllbereichen FB. Wie in diesem vierten Ausführungsbeispiel gezeigt, können die in den Diffusionsgebieten D und SO ausgebildeten Füllbereiche FB aus einer Kombination verschiedener geometrischer Formgestaltungen erzeugt sein.

In einem weiteren Ausführungsbeispiel gemäß Fig. 6 sind die Füllbereiche als 4-eckige Säulen ausgebildet. Wie in der Draufsicht gemäß Fig. 6 zu erkennen ist, sind die Füllbereiche FB in den jeweiligen Diffusionsgebieten D und inhomogen verteilt und mit einer in den entsprechenden Gebieten des jeweiligen Diffusionsgebiets D und SO entsprechenden Konzentrationsdichte angeordnet.

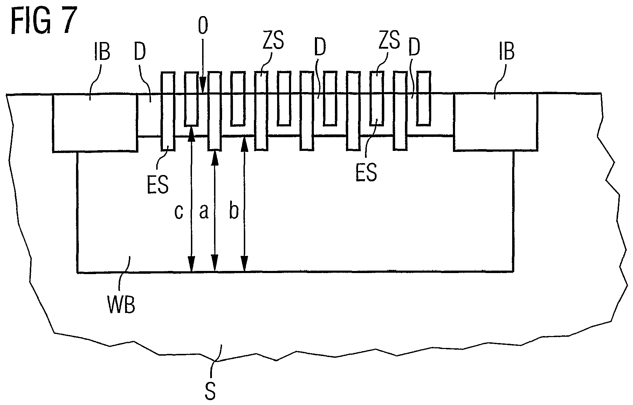

In einem fünften Ausführungsbeispiel gemäß Fig. 7, ist ein erfindungsgemäßer Transistor in einer weiteren Schnittdarstellung gezeigt. In diesem Ausführungsbeispiel sind die Füllbereiche FB aus einem ersten Teilstück ES und einem zweiten Teilstück ZS gebildet. Die Füllbereiche FB weisen unterschiedliche vertikale Ausmaße auf. In der Schnittdarstellung benachbarte erste Teilstücke ES eines jeweiligen Füllbereichs FB weisen unterschiedliche vertikale Ausmaße auf, wobei das erste Teilstück ES eines ersten Füllbereichs FB mit einer Tiefe ausgebildet ist, die größer ist als die Tiefe des Draingebietes D, und dieses erste Teilstück ES einen Abstand a von der Substratoberfläche bzw. dem Bodenbereich des Wannenbereichs WB aufweist. Ein dazu in horizontaler Richtung benachbartes erstes Teilstück ES eines benachbarten weiteren Füllbereichs FB wird mit einer Tiefe ausgebildet, die kleiner ist als die Tiefe des Draingebietes D und einen Abstand c zu der Substratoberfläche bzw. zu dem Boden des Wannenbereichs WB aufweist.

In allen Ausführungsbeispielen kann auch vorgesehen sein, dass die Struktur bzw. die Gestaltung und Anordnung der Füllbereiche in dem Draingebiet D unterschiedlich zu dem im Sourcegebiet SO ist. Die zweiten Teilstücke ZS der jeweiligen Füllbereiche FB sind mit im Wesentlichen identischer vertikaler Ausdehnung ausgebildet. In diesem Ausführungsbeispiel ist gezeigt, dass es auch möglich ist, dass zwei Füllbereiche FB in einem Diffusionsgebiet SO und/oder D jeweils zumindest ein Teilstück aufweisen, welche aus im Wesentlichen gleichen Materialien ausgebildet sind, aber unterschiedliche vertikale Ausmaße aufweisen. Die vollständigen Füllbereich FB weisen ebenfalls unterschiedliche vertikale Ausmaße auf. Jeder Füllbereich ist jedoch derart ausgebildet, dass seine gesamte vertikale Ausdehnung bzw. seine gesamte vertikale Länge zumindest gleich groß der vertikalen Ausdehnung des Draingebietes D und/oder des Sourcegebietes SO ist.

Der erfindungsgemäße Transistor kann als MOS(Metal Oxide Semiconductor) ausgebildet sein.

In allen Ausführungsbeispielen kann des Weiteren vorgesehen sein, dass eine Salizid-Schicht auf dem Sourcegebiet SO und/oder dem Draingebiet D angeordnet ist, wobei in diese Salizid-Schicht die Struktur der Füllbereiche FB übertragen ist. Dadurch können Kristallspannungen reduziert werden und damit die Eigenschaften des Transistors, bspw. die Leckstromproblematik, verbessert werden.

Wie in allen Ausführungsbeispielen zu erkennen ist, ist es für die Erfindung nicht notwendig, dass die Draingebiete D und/oder Sourcegebiete SO von den Füllbereichen FB vollständig durchtrennt bzw. durchdrungen werden, aber vertikale Ausmaße aufweisen, die zumindest gleich groß den vertikalen Ausmaßen des jeweiligen Diffusionsgebietes D und/oder SO sind. Dabei ist es möglich, dass die Füllbereiche FB sich über die Oberfläche O hinaus vom Substrat weg erstrecken.

Wie in allen Ausführungsbeispielen gezeigt, erstrecken sich die Füllbereiche FB in vertikaler Richtung betrachtet nicht unterhalb von Spacerbereichen bzw. des Gate-Bereichs des Transistors. Die Füllbereiche FB sind daher in horizontaler Richtung betrachtet beabstandet zu den Spacerbereichen bzw. zum Gate-Bereich des Transistors angeordnet, wie auch in den Darstellungen in den Figuren 1, 5 und 6 zu sehen ist.

Wesentlich für die Erfindung ist es, dass die geometrische Gestaltung der Füllbereiche FB derart erfolgt, dass das ineinander greifen bzw. das ineinander erstrecken der Füllbereiche FB und der Source- und/oder Draingebiete SO und D des Transistors derart ermöglicht wird, dass eine Kennlinienverschiebung bzw. eine Verschiebung der Kenngrößen des Transistors unabhängig von dessen Größe, dessen Geometrie und dessen Umgebung auf dem integrierten Schaltkreis verhindert werden kann. Jeder Transistor eines integrierten Schaltkreises kann dadurch derart ausgebildet werden, dass er unabhängig von der jeweils verwendeten Prozesstechnologie seine Kenngrößen bzw. seine Kennlinie nahezu unverändert beibehält. Durch die Erfindung kann daher ein von dem physikalischen Effekt eines ESD-Ereignisses unabhängiger physikalischer Effekt, nämlich die Verschiebung von Kenngrößen, insbesondere die Verschiebung der Einsatzspannung, verhindert werden.

## Patentansprüche

1. Transistor, mit
- einem Source- (SO) und einem Draingebiet (D), welche in einem Substrat (S) ausgebildet sind, und
- einer Mehrzahl von Füllbereichen (FB), wobei jeder Füllbereich (FB) zumindest teilweise im Substrat angeordnet ist, und sich die Füllbereiche (FB) und das Source- (SO) und/oder Draingebiet (D) ineinander erstrecken,
- die Füllbereiche (FB) vertikale Ausmaße aufweisen, die mindestens gleich groß den vertikalen Ausmaßen des Source- (SO) und/oder Draingebiets (D) sind,
wobei die Füllbereiche (FB) jeweils zumindest zwei Teilstücke (ES, ZS) aufweisen, welche vertikal direkt übereinander angeordnet sind, wobei erste Teilstücke (ES) der Füllbereiche (FB) und das Source-(SO) und/oder Draingebiet (D) an der dem Substrat (S) abgewandten Oberfläche (O) eine im Wesentlichen planare Fläche bilden, wobei zweite Teilstücke (ZS) der Füllbereiche (FB) direkt auf den ersten Teilstücken (ES) und deckungsgleich zu den ersten Teilstücken (ES) angeordnet sind, und wobei
die zweiten Teilstücke (ZS) schwach elektrisch leitend im Vergleich zum Source- (SO) und/oder Draingebiet (D), aus Poly-Silizium ausgebildet sind.

2. Transistor nach Anspruch 1,
**dadurch gekennzeichnet, dass** die Füllbereiche (FB) derart angeordnet sind, dass sie das Source- (SO) und/oder Draingebiet (D) in vertikaler Richtung vollständig durchdringen.

3. Transistor nach Anspruch 1 oder 2,
**dadurch gekennzeichnet, dass** erste Teilstücke (ES) der Füllbereiche (FB) mit einem Abstand (a) zum Substrat angeordnet sind, der kleiner ist als der Abstand (b) den das Source- (SO) und/oder Draingebiet (D) zum Substrat (S) aufweist.

4. Transistor nach einem der vorhergehenden Ansprüche, **dadurch gekennzeichnet, dass** die Füllbereiche (FB) zumindest in Teilbereichen elektrisch isolierend sind.

5. Transistor nach Anspruch 4, **dadurch gekennzeichnet, dass** die ersten Teilstücke der Füllbereiche (FB) als Oxid-Bereiche, insbesondere Siliziumdioxid, und/oder Nitrid-Bereiche ausgebildet sind.

6. Transistor nach einem der vorhergehenden Ansprüche, **dadurch gekennzeichnet, dass** die Füllbereiche (FB) als im wesentlichen parallel zueinander angeordnete Streifen ausgebildet sind, die insbesondere in der Ebene, in der sich der Gate-Bereich (G) des Transistors erstreckt, senkrecht zu dem Gate-Bereich (G) angeordnet sind.

7. Transistor nach einem der vorhergehenden Ansprüche, **dadurch gekennzeichnet, dass** die Füllbereiche (FB) als Vollzylinder oder als Hohlzylinder oder als eckige Säulen ausgebildet sind.

8. Transistor nach einem der vorhergehenden Ansprüche, **dadurch gekennzeichnet, dass** die Füllbereiche (FB) in zumindest einem der beiden Diffusionsgebiete (D, SO) unterschiedliche geometrische Formen und/oder vertikale Ausmaße aufweisen.

9. Transistor nach einem der vorhergehenden Ansprüche, **dadurch gekennzeichnet, dass** auf dem Source- (SO) und/oder Draingebiet (D) und/oder auf den Füllbereichen (FB) eine Salizid-Schicht ausgebildet ist.

10. Transistor nach Anspruch 9,
**dadurch gekennzeichnet, dass** die Struktur der Füllbereiche (FB) in der Salizid-Schicht ausgebildet ist.

## Claims

1. Transistor having
- a source (SO) and a drain region (D) which are formed in a substrate (S),
- two or more fill areas (FB) with each fill area (FB) being arranged at least partially in the substrate and with the fill areas (FB) and the source (SO) and/or drain region (D) extending into one another,
- the fill areas (FB) have vertical dimensions which are at least of equal size to the vertical dimensions of the source (SO) and/or drain region (D),
wherein the fill areas (FB) each have at least two pieces (ES, ZS) which are arranged vertically directly one above the other, wherein first pieces (ES) of the fill areas (FB) and the source (SO) and/or drain region (D) form an essentially planar surface on the surface (O) facing away from the substrate (S), wherein second pieces (ZS) of the fill areas (FB) are arranged directly on the first pieces (ES) and coincidentally with respect to the first pieces (ES), and wherein the second pieces (ZS) are slightly electrically conductive in comparison to the source (SO) and/or drain region (D), and are composed of polysilicon.

2. Transistor according to Claim 1,
**characterized in that**
the fill areas (FB) are arranged such that they pass completely through the source (SO) and/or drain region (D) in the vertical direction.

3. Transistor according to Claim 1 or 2,
**characterized in that**
first pieces (ES) of the fill areas (FB) are arranged at a distance (a) from the substrate which is less than the distance (b) between the source (SO) and/or drain region (D) and the substrate (S).

4. Transistor according to one of the preceding claims,
**characterized in that**
the fill areas (FB) are electrically insulating at least in subareas.

5. Transistor according to Claim 4,
**characterized in that**
the first pieces of the fill areas (FB) are oxide areas, in particular silicon dioxide, and/or nitride areas.

6. Transistor according to one of the preceding claims,
**characterized in that**
the fill areas (FB) are strips which are arranged essentially parallel to one another and are arranged at right angles to the gate area (G), in particular on the plane on which the gate area (G) of the transistor extends.

7. Transistor according to one of the preceding claims,
**characterized in that**
the fill areas (FB) are solid cylinders, hollow cylinders, or polygonal pillars.

8. Transistor according to one of the preceding claims,
**characterized in that**
the fill areas (FB) have different geometric shapes and/or vertical dimensions in at least one of the two diffusion regions (D, SO).

9. Transistor according to one of the preceding claims,
**characterized in that**
a salicide layer is formed on the source (SO) and/or drain region (D) and/or on the fill areas (FB).

10. Transistor according to Claim 9,
**characterized in that**
the structure of the fill areas (FB) is formed in the salicide layer.

## Revendications

1. Transistor, comportant
- une zone de source (SO) et une zone de drain (D) qui sont réalisées dans un substrat (S), et
- une pluralité de régions de remplissage (FB), dans lequel chaque région de remplissage (FB) est disposée au moins en partie dans le substrat et les régions de remplissage (FB) et les zones de source (SO) et/ou de drain (D) s'étendant les unes dans les autres,
- les régions de remplissage (FB) présentent des dimensions verticales qui sont au moins identiques aux dimensions verticales des zones de source (SO) et/ou de drain (D),
dans lequel les régions de remplissage (FB) comportent respectivement au moins deux tronçons (ES, ZS) qui sont disposés verticalement directement l'un sur l'autre, dans lequel des premiers tronçons (ES) des régions de remplissage (FB) et la zone de source (SO) et/ou de drain (D) forment sur la surface (O) opposée au substrat (S) une surface sensiblement plane, dans lequel deux tronçons (ZS) des régions de remplissage (FB) sont directement disposés sur les premiers tronçons (ES) et de manière à coïncider avec les premiers tronçons (ES), et dans lequel les deuxièmes tronçons (ZS) sont réalisés en polysilicium de manière à ce qu'ils soient faiblement conducteurs électriquement par comparaison à la zone de source (SO) et/ou de drain (D).

2. Transistor selon la revendication 1,
**caractérisé en ce que** les régions de remplissage (FB) sont disposées de manière à ce qu'elles traversent entièrement la zone de source (SO) et/ou de drain (D) dans la direction verticale.

3. Transistor selon la revendication 1 ou 2,
**caractérisé en ce que** des premiers tronçons (ES) des régions de remplissage (FB) sont disposés à une distance (a) du substrat qui est inférieure à la distance (b) que présente la zone de source (SO) et/ou de drain (D) par rapport au substrat (S).

4. Transistor selon l'une quelconque des revendications précédentes,
**caractérisé en ce que** les régions de remplissage (FB) sont électriquement isolantes au moins dans des régions partielles.

5. Transistor selon la revendication 4, **caractérisé en ce que** les premiers tronçons des régions de remplissage (FB) sont réalisés sous la forme de régions d'oxyde, notamment d'oxyde de silicium et/ou de zones de nitrure.

6. Transistor selon l'une quelconque des revendications précédentes,
**caractérisé en ce que** les régions de remplissage (FB) sont réalisées sous la forme de bandes agencées sensiblement parallèlement les unes aux autres, qui sont disposées perpendiculairement à la région de grille (G), notamment dans le plan dans lequel s'étend la région de grille (G) du transistor.

7. Transistor selon l'une quelconque des revendications précédentes,
**caractérisé en ce que** les régions de remplissage (FB) sont réalisées sous la forme de cylindres pleins ou de cylindres creux ou de colonnes polygonales.

8. Transistor selon l'une quelconque des revendications précédentes,
**caractérisé en ce que** les régions de remplissage (FB) présentent, dans au moins l'une des deux zones de diffusion (D, SO), des formes géométriques et/ou des dimensions verticales différentes.

9. Transistor selon l'une quelconque des revendications précédentes,
**caractérisé en ce qu'**une couche de saliciure est formée sur la zone de source (SO) et/ou de drain (D) et/ou sur les régions de remplissage (FB).

10. Transistor selon la revendication 9,
**caractérisé en ce que** la structure des régions de remplissage (FB) est réalisée dans la couche de saliciure.
